# FASCICULE DE BREVET EUROPEEN

(11) **EP 2 994 763 B1**
(45) Date de publication et mention de la délivrance du brevet: **03.01.2024**
(21) Numéro de dépôt: 14727887.3
(22) Date de dépôt: 06.05.2014
(51) Int. Cl.: G01R 19/25

(54) **PROCEDE ET SYSTEME D'ANALYSE DE LA CONSOMMATION D'ELECTRICITE**
VERFAHREN UND SYSTEM ZUR ANALYSE EINES STROMVERBRAUCHS
METHOD AND SYSTEM FOR ANALYSING ELECTRICITY CONSUMPTION

(30) Priorité: 06.05.2013 FR 1354125
(43) Date de publication de la demande: 16.03.2016
(73) Titulaire: Smart Impulse, 75018 Paris (FR)
(72) Inventeur: LABATIE, Antoine, F-75014 Paris (FR)
(74) Mandataire: IP Trust
(86) Numéro de dépôt international: PCT/FR2014/051062
(87) Numéro de publication internationale: WO 2014/181062

(56) Documents cités:
- EP-A2- 2 402 771
- WO-A1-2012/103138
- WO-A1-2012/168629
- GB-A- 2 471 536
- GB-A- 2 475 172
- US-A1- 2010 280 978
- HSUEH-HSIEN CHANG ET AL: "A New Measurement Method for Power Signatures of Nonintrusive Demand Monitoring and Load Identification", IEEE TRANSACTIONS ON INDUSTRY APPLICATIONS, IEEE SERVICE CENTER, PISCATAWAY, NJ, US, vol. 48, no. 2, 1 mars 2012 (2012-03-01), pages 764-771, XP011434193, ISSN: 0093-9994, DOI: 10.1109/TIA.2011.2180497

## Description

### Domaine de l'invention

La présente invention concerne le domaine de l'analyse de la consommation électrique d'un site résidentiel, tertiaire ou industriel non intrusive, c'est-à-dire ne nécessitant pas la mise en place de capteurs associés à chacun des équipements à superviser. Cette analyse permet notamment d'identifier les principaux leviers d'économie d'énergie.

### Etat de la technique

On connaît dans l'état de la technique différentes solutions consistant à acquérir des informations sur les facteurs de forme du courant et/ou de la tension d'alimentation en amont du site et à déduire des informations sur la consommation individuelle de chacun des équipements électriques.

Une première famille de solutions consiste à observer les variations temporelles de la courbe de charge et à identifier des signatures comparées avec des signatures de référence enregistrées pour les principaux équipements.

En particulier, la demande de brevet européen EP2000780 décrit un procédé de détection et d'estimation de la consommation des usages électriques des installations d'un souscripteur, caractérisé en ce qu'il consiste au moins à :
- établir la courbe de consommation électrique générale des installations du souscripteur, l'étape consistant à établir la courbe de consommation générale des installations du souscripteur incluant au moins : l'échantillonnage de la consommation des effluents consommés par les installations du souscripteur, ledit échantillonnage intervenant en aval du compteur de consommation d'effluent relié au branchement au réseau général ;
- effectuer, par segmentation de la courbe de consommation générale des installations du souscripteur et par suivi des événements de consommation électrique en régime transitoire, la reconnaissance des usages électriques et estimer leur consommation correspondante.

On connaît également la demande de brevet international WO 2010106253 décrivant un procédé d'analyse de la consommation électrique d'une pluralité d'appareils électriques fonctionnant sur un site de consommation, par filtrage d'une courbe de charge représentant la consommation électrique desdits appareils en fonction du temps, caractérisé en ce qu'il comporte les étapes suivantes :
- préalablement au filtrage proprement dit de la courbe de charge
- enregistrer et numériser la courbe de charge, de façon à obtenir une courbe de charge numérisée par périodes de temps;
- définir un ensemble de classes d'appareils, chaque classe étant définie par des cycles similaires de variation de puissance ;
- définir pour chaque classe d'appareils, un algorithme de filtrage de la courbe de charge dédié à ladite classe d'appareils, ledit algorithme étant apte à extraire des cycles de variation de puissance de la courbe de charge numérisée, et à l'allouer à ladite classe d'appareils ;
- puis pendant le filtrage proprement dit de la courbe de charge numérisée, utiliser successivement les algorithmes de filtrage dédiés à chaque classe d'appareils, pour identifier et regrouper à partir de la courbe de charge numérisée, les cycles de variations de puissance consommée par les appareils électriques. Une deuxième famille de solutions consiste à prendre en compte non pas la variation temporelle de la puissance mesurée en amont de l'installation, mais à prendre en compte la forme d'onde du courant consommé par chacun des équipements.

En particulier, la demande de brevet internationale WO2011012840 concerne un procédé d'identification du fonctionnement d'un appareil électrique, par exemple un moteur à induction. Le procédé comprend l'identification du fonctionnement d'un appareil électrique lorsqu'un trajet tracé par des valeurs de puissance réelle par rapport à des valeurs de puissance virtuelle correspondantes sur une période particulière comprend un ou plusieurs arcs sensiblement circulaires. Les valeurs de puissance réelle sont associées à la puissance réelle totale fournie à un ou plusieurs appareils électriques en fonction du temps, et les valeurs de puissance virtuelle sont associées à la puissance virtuelle totale fournie à un ou plusieurs appareils électriques en fonction du temps. L'invention concerne également un procédé associé d'identification du fonctionnement d'un type d'appareil spécifié, dans lequel le fonctionnement dudit type d'appareil spécifié dépend de la fourniture d'au moins une source d'énergie, comme l'électricité, le gaz naturel, ou l'eau. L'invention concerne également des programmes informatiques, des supports pouvant être lus par ordinateur et des produits et appareils de programme informatique correspondants.

Dans la même famille de solutions, le brevet européen EP1296147 décrit un procédé pour estimer la consommation d'électricité individuelle d'une pluralité d'appareils électriques consistant à :
- créer un modèle pour estimer la consommation d'électricité de chacun des appareils électriques à partir des relations entre les données concernant des harmoniques fondamentales et supérieures de courant de pleine charge et leurs différences de phase de tension à partir du courant de pleine charge et de la tension obtenus à partir de combinaisons de différents états d'utilisation d'une pluralité d'appareils électriques et la consommation électriques utilisées pour obtenir lesdites données
- et obtenir la consommation d'électricité d'appareils individuels en fonctionnement en utilisant ledit modèle pour estimer la consommation de chaque appareil à partir desdites harmoniques fondamentales et supérieures dudit courant de pleine charge et de leurs dites différences de phase de tension obtenues à partir dudit courant de pleine charge et de la tension mesurés dans un voisinage d'une entrée de service.

On connaît également la demande de brevet internationale WO2012168629 de la demanderesse décrivant l'invention d'un procédé d'analyse de la consommation d'électricité d'un site équipé d'une pluralité d'équipements électriques de natures différentes, consistant à :
- mesurer périodiquement le courant et la tension sur au moins une des phases électriques en amont du réseau d'alimentation du site
- appliquer sur une combinaison des signaux numérisés un traitement pour déterminer la répartition de la consommation en fonction d'une partie au moins desdits équipements en fonction d'une signature de chacun desdits équipements, caractérisé en ce que ledit traitement consiste à comparer la forme d'onde de courant mesurée à une bibliothèque de signatures préalablement enregistrée pour chacun desdits équipements électriques, lesdites signatures comportant au moins un paramètre fonction de la forme d'onde de la tension d'alimentation
- déterminer et enregistrer la signature de chacun des équipements lors d'une étape préalable consistant à appliquer à chacun des équipements une série prédéterminée de séquences d'alimentation avec des signaux de tension dont la forme d'onde est représentative des formes d'onde observées sur les installations électriques usuelles

### Inconvénients de l'état de la technique

Les procédés consistant à observer les variations temporelles de la courbe de charge et à identifier des signatures comparées avec des signatures de référence enregistrées pour les principaux équipements ne sont pas adaptés à l'analyse de sites comportant un nombre important d'équipements. En effet, la périodicité des acquisitions est de l'ordre de la seconde. Lorsque plusieurs équipements s'arrêtent ou démarrent avec un décalage temporel faible, inférieure à la périodicité d'acquisition, il se produit un phénomène de masquage qui empêche une reconnaissance pertinente des équipements en question.

Par ailleurs, le procédé ne prend en compte que les transitoires (allumage/arrêt), et ne permet pas de prendre en compte des équipements en fonctionnement permanent.

Ces problèmes ont conduit à développer la deuxième famille de solutions, basée sur l'analyse des formes d'onde.

Le problème technique que pose ces procédés est celui de la robustesse des traitements. En effet, ces procédés sont basés sur la caractérisation d'un équipement par une signature enregistrée dans une situation particulière. Lorsque l'équipement est utilisé sur un site, cette signature est légèrement perturbée, notamment par la qualité de la tension d'alimentation. Il est donc nécessaire de prévoir une marge d'erreur pour permettre la détection effective des équipements. Cette marge d'erreur conduit néanmoins à un risque de confusion entre équipements distincts, mais caractérisés chacun par des signatures proches.

Pour réduire ce risque, les procédés connus dans l'état de la technique nécessitent une étape de paramétrage local fastidieuse, réalisable seulement par un opérateur humain présent sur le site pendant une durée relativement longue. Cette étape de paramétrage locale consiste à générer chacune des signatures en procédant à une mesure de courant et de tension sur l'alimentation électrique des équipements, lorsqu'ils sont en fonctionnement.

On connaît enfin le brevet EP2402771 décrivant un dispositif de surveillance de puissance pour identifier l'état d'un appareil électrique sur la base des évaluations d'utilisateur et un procédé de surveillance de puissance de celui-ci sont prévus.

Le dispositif de contrôle de puissance comprend un module de mesure, une détection de variation et le module de recherche, et une base de données de signature de l'appareil électrique établi sur la base des évaluations des utilisateurs.

Lorsque le module de mesure détecte une variation d'une caractéristique de consommation de puissance, la détection de variation et le module de recherche dans la base de la signature de l'appareil électrique en fonction de la variation d'obtenir des appareils électriques semblables à la variation et les états de ceux-ci.

Un utilisateur fournit des données à la base de données de signature de l'appareil électrique en confirmant le résultat de recherche, ou en sélectionnant l'appareil électrique correcte et l'état de celui-ci.

Lorsque l'utilisateur confirme le résultat de recherche, le dispositif de contrôle de puissance établit une association entre l'appareil électrique et les signatures de l'appareil électrique et met à jour la base de données de la signature de l'appareil électrique.

En particulier, le brevet EP2402771 propose d'utiliser la signature commune à tous les utilisateurs, et ne prend pas en compte le contexte de l'immeuble et les perturbations occasionnées par le réseau.

### Solution apportée par l'invention

A cet effet, l'invention concerne selon son acception la plus générale un procédé d'analyse de la consommation d'électricité d'un site équipé d'une pluralité d'équipements électriques de natures différentes, présentant les caractéristiques énoncées par la revendication 1.

Le procédé consiste à :
- échantillonner au moins le signal de courant à une fréquence au moins 30 fois supérieure à la fréquence fondamentale de la tension d'alimentation électrique
- appliquer une transformée de Fourrier sur chaque période fondamentale du signal de courant au moins
- procéder à un lissage temporel dudit signal transformé en calculant une moyenne temporelle sur une période caractéristique de changement de comportement des équipements du réseau (période suffisamment longue par rapport à la période porteuse ; suffisamment courte pour ne pas recouvrir plusieurs évènements)
- constituer une base de signatures adaptée au site étudié pendant une première étape de mise en oeuvre, consistant à :
   ∘ enregistrer pendant une période longue des signatures candidates susceptibles d'être associées à une variation de consommation d'un desdits équipements
   ∘ ajouter optionnellement dans ladite base des signatures préqualifiées
   ∘ faire évoluer itérativement les paramètres des signatures non préqualifiées
   ∘ enregistrer dans une base de référence les signatures les plus représentatives des événements liés au fonctionnement desdits équipements
   ∘ qualifier optionnellement chacune des signatures enregistrées dans ladite base par rapport à un événement associé
- utiliser ensuite ladite base de signatures de référence pour qualifier les évènements survenant sur ledit réseau
Cette solution permet d'éviter l'intervention d'un opérateur sur site par une auto-configuration du système pour constituer de manière automatisée une base de signature parfaitement conforme aux événements que l'on souhaite détecter.

### Description détaillée d'un mode non limitatif de réalisation

La présente invention vise à apporter une solution technique aux problèmes posés par les procédés d'analyse de l'état de la technique.

A cet effet, l'invention concerne, selon son acception la plus générale, un procédé d'analyse de la consommation d'électricité d'un site équipé d'une pluralité d'équipements électriques de natures différentes, consistant à mesurer périodiquement le courant et la tension sur au moins une des phases électriques en amont du réseau d'alimentation du site, à appliquer sur une combinaison des signaux numérisés un traitement pour déterminer la répartition de la consommation en fonction d'une partie au moins desdits équipements, caractérisé en ce que ledit traitement consiste à comparer la forme d'onde de courant mesurée à un catalogue de signatures correspondant aux éléments électriques présents sur le site en question, dont une partie au moins est constitué de signatures extraites lors d'une étape de configuration à partir d'un historique de données de forme d'onde de courant relevées sur le site, et une autre partie peut provenir d'une bibliothèque de signatures enregistrées à l'avance, lesdites signatures et les courbes de consommation temporelles associées étant finalement affectées aux équipements électriques du site.

De préférence, après l'extraction de nouvelles signatures à l'étape de configuration, ces signatures sont autorisées à varier légèrement afin de permettre la décomposition des formes d'onde de courant mesurées comme une combinaison linéaire des signatures extraites perturbées et des signatures fixées qui ont été enregistrées à l'avance, avec pour chaque signature, des consommations associées qui soient positives. Les perturbations des signatures extraites permettent notamment de prendre en compte la variabilité des signatures réelles dues aux variations de la forme d'onde de tension d'alimentation, ainsi que la variabilité intrinsèque des signatures réelles.

De préférence, la signature d'une partie au moins desdits équipements est fonction d'une combinaison de signatures des éléments électriques mis en oeuvre par l'équipement considéré. Avantageusement, on procède en outre à un traitement prenant en compte le cycle d'activation des éléments électriques constitutifs de chacun des équipements considérés.

De préférence, une partie au moins des signatures comporte au moins un paramètre fonction de la forme d'onde de la tension d'alimentation observée.

Selon un mode de mise en oeuvre particulier, on associe à une partie au moins des équipements un catalogue de signatures, chacune des signatures dudit catalogue d'un équipement considéré prenant en compte la forme d'onde de tension du signal d'alimentation mesuré au moment de l'acquisition de la signature.

Selon un mode de mise en oeuvre préféré, le traitement d'analyse consiste à appliquer une première étape de calcul d'une transformée de Fourier Rapide sur les signaux de courant et de tension.

Avantageusement, le traitement d'analyse consiste à appliquer une deuxième étape de décomposition du résultat de la transformée de Fourier Rapide en fonction des signatures caractéristiques de chacun desdits équipements.

Selon une variante, le traitement d'analyse consiste à appliquer une étape additionnelle de validation des résultats de l'étape de décomposition consistant à vérifier la présence de variations temporelles des formes d'onde de courant de chacun des éléments reconnus. De préférence, le traitement d'analyse comporte une étape additionnelle d'association des éléments reconnus pour identifier les équipements concernés.

L'invention concerne également le procédé d'extraction de nouvelles signatures d'équipements électriques présents sur un site donné, à partir d'un historique de données de formes d'onde de courant mesurées sur ledit site.

De préférence, l'extraction de ces signatures est effectuée par un algorithme d'optimisation mathématique visant à minimiser une fonction objectif qui dépend desdites signatures sur un historique de données de forme d'onde de courant mesurées sur le site en question. A chaque itération de l'optimisation, et les formes d'onde de courant sont décomposées comme combinaisons linéaires des signatures estimées à ce moment de l'optimisation, en multipliant la signature de la forme d'onde de courant par la matrice pseudo-inverse de la matrice construite par agrégation des signatures estimées. Les coefficients de ces combinaisons linéaires fournissent les courbes temporelles de consommation de puissance réelle associées à ces signatures sur l'historique de données. La fonction objectif est calculée directement à partir de ces courbes de puissance réelle. L'algorithme met à jour l'estimation des signatures à chaque itération dans le but de minimiser la fonction objectif.

Avantageusement, la fonction objectif calculée avec les courbes de puissance réelle associées à chaque signature, est constituée d'une somme de trois sous-fonctions. Une première sous-fonction pénalise la négativité des courbes de consommation pour chaque signature. Une deuxième sous-fonction pénalise la corrélation entre les dérivées des courbes de consommation des différentes signatures, c'est-à-dire pénalise les variations de puissance corrélées des différentes signatures. Enfin, la troisième sous-fonction favorise la non-gaussianité des dérivées des courbes de puissance réelle des différentes signatures, en utilisant le même principe que les méthodes d'analyse en composantes indépendantes.

Dans un mode de réalisation particulier, certaines signatures peuvent être fixées durant tout le processus d'optimisation, si bien que l'optimisation ne concerne que la partie du catalogue de signatures en dehors desdites signatures fixées. Ces signatures peuvent être des signatures d'appareils génériques, comme par exemple des signatures d'appareils purement résistifs. Avantageusement, ces signatures génériques ont été enregistrées préalablement avec un paramètre dépendant de la forme d'onde de la tension d'alimentation, cette même paramétrisation étant utilisée à chaque itération de l'optimisation, pour incorporer ces signatures dans le catalogue de signatures en fonction de la forme d'onde de la tension d'alimentation à chaque instant de l'historique, et pour obtenir la décomposition en puissance réelle des différentes signatures. Les signatures fixées dans le catalogue peuvent également être des signatures d'appareils électriques spécifiques au site étudié et mesurées sur ledit site.

Selon une variante, le procédé comporte en outre une étape de traitement complémentaire de décomposition de chaque signature extraite sur une base de signatures connues afin de déterminer si elle est unitaire ou non.

L'invention concerne également un procédé de construction d'une bibliothèque de signatures et de modélisation des équipements en vue de la mise en oeuvre du procédé d'analyse précité caractérisé en ce que l'on alimente les différents éléments électriques constitutifs dudit équipement par une tension de forme d'onde de référence, et d'enregistrement de données numériques représentatives de la forme d'onde des signaux de tension et de courant mesurés.

De préférence, on enregistre pour chaque équipement un catalogue de signatures correspondant chacune à la forme d'onde des signaux de tension et de courant mesurés lors de l'alimentation avec une tension de forme d'onde différente.

### Exemple détaillé de réalisation

La présente invention sera mieux comprise à la lecture de la description qui suit d'un exemple non limitatif de réalisation, se référant aux dessins annexés où :
- la figure 1 représente une vue schématique d'une installation équipée d'un moyen d'analyse selon l'invention
- la figure 2 représente le diagramme des étapes mises en oeuvre par le procédé
- Les figures 3 et 4 représentent, pour une forme d'onde de tension fixée, respectivement la forme d'onde de courant d'un appareil électrique, et l'histogramme des harmoniques résultant de l'application d'un transformé de Fourier Rapide au signal de courant
- la figure 5 représente une vue schématique des traitements appliqués sur les signaux de courant et de tension mesurés à l'entrée du réseau d'alimentation du site
- la figure 6 représente une vue schématique des traitements appliqués sur les signaux de courant et de tension, à la suite de l'étape d'extraction de signatures, jusqu'à l'étape finale de décomposition de la consommation globale en consommation suivant les équipements présents sur le site
- la figure 7 représente une vue de l'algorithme de minimisation
- la figure 8 présente une forme d'onde non unitaire extraite
- les figures 9 et 10 présentent les formes d'onde unitaires résultant de la décomposition de la forme d'onde non unitaire.

### Présentation de l'installation

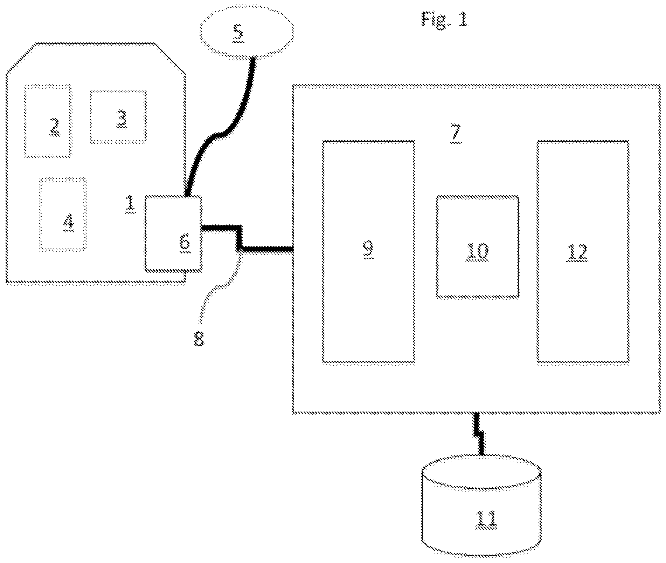

La figure 1 représente un exemple de mise en oeuvre de l'invention.

Le site (1) est constitué par exemple par un bâtiment d'habitation individuel ou collectif, un immeuble de bureau ou un bâtiment industriel, ou encore un parc regroupant plusieurs bâtiments.

Dans ce bâtiment sont implantés différents équipements électriques (2 à 4), par exemple un ordinateur, une lampe d'éclairage, un équipement électroménager, un équipement de chauffage ou de climatisation, etc.

Ces différents équipements sont branchés sur un réseau électrique privatif dont l'architecture est habituelle, ce réseau privatif étant lui-même relié au réseau électrique d'un distributeur d'énergie (5) par l'intermédiaire d'un poste de raccordement (6), par exemple un tableau général basse tension associé à un poste de livraison.

On installe dans ce poste de raccordement des capteurs de tension et de courant.

Sur chacune des phases d'alimentation, on installe des boucles de Rogowski qui fournissent un signal fonction du courant avec une grande précision.

Pour la mesure des tensions, on raccorde à chacune des phases un câble relié à l'outil d'analyse (7). L'outil d'analyse (7) est relié au poste de raccordement (6) par un faisceau de câbles (8) pour la transmission des formes d'onde des courants et tensions mesurées.

### Mesure de la tension

Sur un réseau monophasé (un conducteur de neutre et une phase) ou triphasé (trois phases et éventuellement un neutre), la tension est la grandeur électrique fournie par le distributeur d'Energie sur chaque phase. Chaque appareil électrique branché à une prise de courant y est soumis.

Afin de connaître l'environnement électrique du réseau observé, nous mesurons la forme d'onde de la tension sur chacune des phases. En effet, le comportement d'un appareil électrique peut varier en fonction de la tension à laquelle il est soumis.

L'information d'intérêt est la forme d'onde de la tension durant une période du signal (20 ms à 50 Hz, par exemple), appelée « période d'observation ». Cette forme d'onde de la tension, assimilable à une onde sinusoïdale ayant subi des perturbations tout au long du réseau reliant la centrale de production au poste de consommation, est acheminée vers une carte électronique puis acquise par un convertisseur analogique-numérique. Elle est ainsi représentée sous forme numérique. Le nombre d'échantillons par période et la profondeur de numérisation doivent être suffisamment grands pour permettre une restitution fidèle et un faible bruit de mesure. L'expérience montre la nécessité d'au moins 64 points par période et d'une profondeur de numérisation de 10 bits minimum.

### Mesure de l'intensité du courant

Chaque appareil connecté à un réseau électrique est soumis à une tension, et conséquemment, consomme un courant. Sur un réseau monophasé, ce courant parcourt le neutre et la phase ; sur un réseau triphasé équilibré, le courant parcourt les trois phases ; sur un réseau triphasé déséquilibré, le courant parcourt les trois phases et le neutre.

Partant du constat que les éléments constitutifs d'un appareil électrique influent sur les perturbations imprimées au courant qui le traverse, nous souhaitons mesurer précisément l'intensité de ce courant.

Pour ce faire, nous employons des capteurs de courant (un par phase) dont le rôle est de générer un signal image du courant qui parcourt un conducteur électrique. Plus précisément, nous utilisons des capteurs non-intrusifs appelés boucle de Rogowski qui se présentent sous la forme d'anneaux à placer autour des câbles d'alimentation d'une installation électrique. Ces anneaux étant ouverts, il n'est pas nécessaire de couper le courant pour les mettre en place.

L'information d'intérêt est la forme d'onde de l'intensité du courant durant une période du signal (20 ms à 50 Hz, par exemple), appelée « période d'observation ». Cette forme d'onde, assimilable à une onde sinusoïdale ayant subi des perturbations suite à son passage dans divers appareils électriques, est acheminée vers une carte électronique puis acquise par un convertisseur analogique-numérique. Elle est ainsi représentée sous forme numérique. Le nombre d'échantillons par période et la profondeur de numérisation doivent être suffisamment grands pour permettre une restitution fidèle et un faible bruit de mesure. L'expérience montre la nécessité d'au moins 64 points par période et d'une profondeur de numérisation de 10 bits minimum.

### Présentation de l'outil d'analyse

Le procédé d'analyse et de répartition de la consommation d'électricité nécessite une chaîne de mesure et d'acquisition performante des formes d'onde des tensions et des courants. Le dispositif (7) sur lequel repose ces étapes est composé des modules suivants.

Les signaux de formes d'onde de courant et de tension, mesurés au niveau du point de raccordement (6) et acheminés par le faisceau de câbles (8), sont numérisés de manière simultanée par des convertisseurs analogique-numérique (9) de haute précision et de faible bruit.

L'unité de traitement (10) réalise des opérations numériques sur les données mesurées et les compare à des références stockées dans une unité de stockage (11) selon le procédé décrit ci-après.

Les résultats ainsi obtenus sont mis à disposition d'appareils tiers ou d'opérateurs par le biais d'une unité de communication (12).

### Présentation de la construction d'une bibliothèque de signatures

Afin de garantir la robustesse des algorithmes mis en oeuvre, nous procédons avant toute analyse à la modélisation d'une pluralité d'appareils électriques. Le but de cette phase est de construire une bibliothèque de signatures correspondant à certains appareils à identifier une fois sur site.

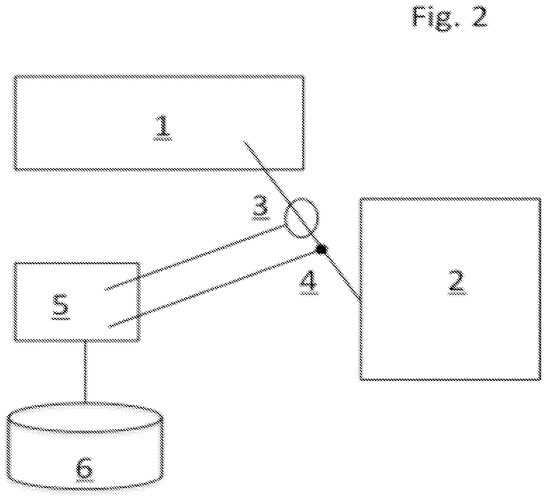

La figure 2 représente une vue schématique du procédé de modélisation. Un appareil électrique (2) est modélisé par une série de formes d'onde de courant capturées alors que l'appareil est alimenté par une série de formes d'onde de tension différentes.

Si cela est possible, on soumet l'appareil électrique à modéliser (2) à une série de formes d'onde de tension générées par une source de tension programmable (1) selon une distribution statistique des formes d'onde de tension habituellement rencontrées sur le site visé ou dans l'absolu. Pour chacune de ces formes d'onde de tension, on mesure grâce à une centrale d'acquisition (5) et à des capteurs de courant (3) et de tension (4) les formes d'onde de la tension d'alimentation et du courant consommé par l'appareil électrique. On stocke le couple de formes d'onde dans le catalogue (6).

Si l'appareil ne peut être alimenté par une source de tension programmable - par souci d'encombrement ou de puissance trop élevée - des mesures sont effectuées sur site sur un temps assez long pour observer des formes d'onde de tension suffisamment différentes.

Par défaut, si l'on ne dispose que d'une seule forme d'onde de courant associée à une seule forme d'onde de tension, on extrapole les résultats pour propager les variations de tension à la forme d'onde de courant.

Une bibliothèque de signatures est obtenue en agrégeant les différentes mesures de forme d'onde de tension et de courant pour chaque appareil modélisé.

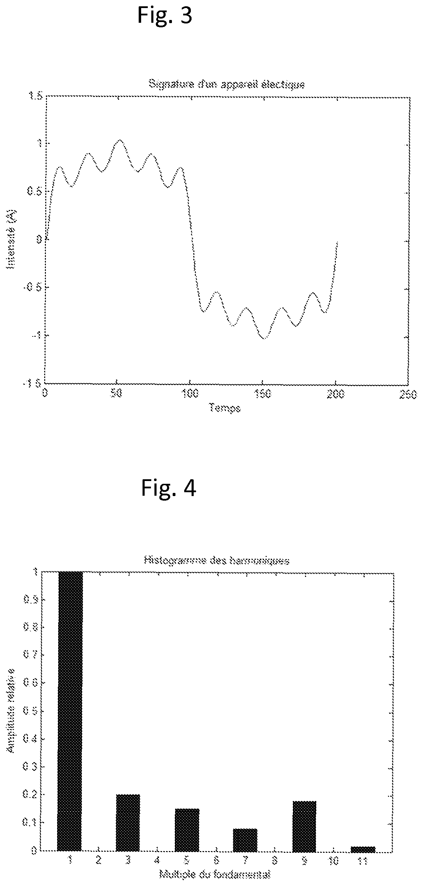

Les figures 3 et 4 représentent, pour une forme d'onde de tension fixée, respectivement la forme d'onde de courant d'un appareil électrique, et l'histogramme des harmoniques résultant de l'application d'un transformé de Fourier Rapide au signal de courant illustré par la figure 4.

La signature est constituée à titre d'exemple des paramètres suivants, pour une forme d'onde de tension fixée :
- la partie réelle des harmoniques successives des signaux de courant
- la partie imaginaire des harmoniques successives des signaux de courant

Ces paramètres permettent de prendre en compte les caractéristiques fréquentielles et temporelles du courant.

Ces paramètres sont à la fois stables et reproductibles, et différenciant des éléments électriques constitutifs des équipements.

### Présentation des traitements des signaux

Le procédé de répartition de la consommation d'électricité repose sur l'analyse des formes d'onde de courant et de tension. Il se décompose en cinq phases : prétraitements des signaux, sélection d'une série de signatures adaptées et fixées dans la matrice des signatures, extraction de nouvelles signatures par un algorithme d'optimisation lors d'une étape de configuration, décomposition des signaux observés en fonction de toutes ces signatures par un second algorithme d'optimisation, affectation des courbes temporelles de consommation des différentes signatures aux équipements présents sur le site.

### Présentation de l'algorithme de configuration

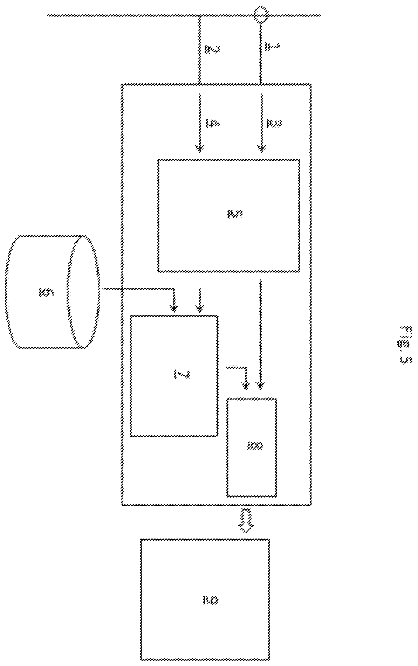

La figure 5 représente une vue schématique des traitements appliqués sur les signaux de courant et de tension mesurés à l'entrée du réseau d'alimentation du site ou d'une partie du site (1,2), jusqu'à l'étape d'extraction de nouvelles signatures.

D'abord, en raison du nombre de transitoires et d'artefacts qui peuvent se produire sur un réseau électrique de grande taille, une étape de débruitage doit être mise en oeuvre (3,4). Il s'agit de mesurer toutes les grandeurs physiques, tensions et intensités, sur un grand nombre de périodes.

Dans un mode de réalisation particulier on isole les mesures qui présentent le moins de fluctuations et on en calcule la moyenne. Nous procédons ainsi : mesure simultanée des formes d'onde de courant et de tension ; calcul des variations des formes d'onde successives ; sélection des périodes les plus semblables ; calcul des formes d'onde moyennes.

Puis, les signaux de tension et de courant débruités sont convertis dans l'espace des fréquences par application d'un algorithme de Transformée de Fourier Rapide (3,4), aussi appelé Fast Fourier Transform (FFT). L'expérience montre qu'il est souvent suffisant de ne considérer que les harmoniques impaires.

On effectue alors une sélection d'appareils électriques parmi une bibliothèque d'appareils préalablement modélisées (6), et correspondant à des appareils électriques présents sur le site (7).

Lorsque l'on dispose de cette sélection et d'un historique de données suffisamment long de données FFT de courant et de tension débruitées (5), on procède à une étape de configuration.

Cette étape de configuration (8) consiste en un algorithme permettant d'extraire les signatures d'appareils électriques présents sur le site étudié, et non incluses dans la sélection initiale d'appareils modélisés. On dispose donc en sortie de l'algorithme d'un catalogue complet de signatures adapté au site étudié (9).

En termes mathématiques, un vecteur de FFT de courant mesuré sur le site à un instant donné de l'historique peut être obtenu par multiplication d'un vecteur constitué des consommations associées aux différentes signatures d'appareils présents sur le site par la matrice dont les différentes colonnes sont données par lesdites signatures, avec une convention de normalisation de ces signatures de sorte qu'elles représentent chacune une consommation unitaire, et en supposant aussi que les différentes signatures sont linéairement indépendantes.

Un exemple simple de signatures non linéairement indépendantes est donné par un ensemble de plus de deux signatures purement sinusoïdales, caractéristiques notamment des équipements purement résistifs et inductifs. Sous ces conditions, on peut simplement retrouver la consommation associée à chaque signature en multipliant le vecteur de FFT de courant mesuré sur le site par la matrice pseudo-inverse de la matrice des signatures.

L'algorithme vise à minimiser une fonction objectif qui dépend de la matrice des signatures. A l'intérieur de cette matrice sont fixées les signatures d'appareils préalablement modélisées qui ont été sélectionnées. La signature électrique d'un appareil étant fonction de la forme d'onde de la tension qui l'alimente, nous procédons pour chaque instant de l'historique, à une sélection des signatures qui correspondent au plus près à la situation rencontrée. Durant l'optimisation, les seules variables laissées libres dans la matrice des signatures sont donc les signatures complémentaires, que l'on appelle les signatures extraites, qui ne sont pas prises en compte dans les signatures fixées, et qui ne présentent pas de dépendance dans la forme d'onde de tension dans la procédure d'optimisation.

Pour une matrice de signatures donnée, l'algorithme calcule les consommations associées à chaque instant de l'historique par la méthode de la pseudo-inverse décrite précédemment. L'algorithme peut alors calculer la fonction objectif qui dépend directement de ces courbes de consommations. La fonction objectif est donnée par la somme de trois sous-fonctions, visant à favoriser ou pénaliser certains comportements de consommation. La première sous-fonction pénalise les valeurs de consommation négatives. La deuxième et la troisième sous-fonctions sont appliquées aux dérivées temporelles des courbes de consommation. La deuxième sous-fonction pénalise la corrélation temporelle entre les dérivées temporelles des courbes de consommation de signatures différentes. Enfin, la troisième sous-fonction favorise la non-gaussianité des dérivées temporelles des courbes de consommation, en utilisant le même principe que les algorithmes d'analyse en composantes indépendantes.

Cette minimisation étant difficile du fait de possibles minima locaux, on procède avantageusement à une initialisation avec un algorithme d'analyse en composantes indépendantes sur les dérivées temporelles des vecteurs FFT des mesures de courant.

Cette initialisation très rapide permet d'optimiser dans un premier temps les deux sous-fonctions qui s'appliquent sur les dérivées des courbes temporelles de consommation.

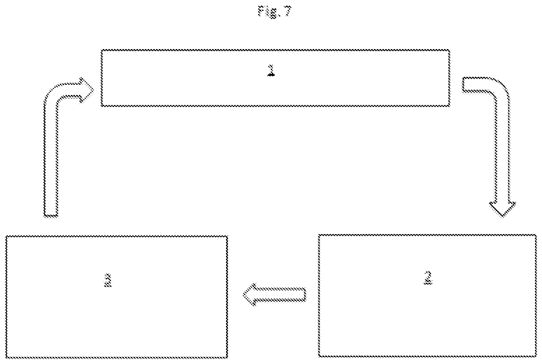

Le fonctionnement général de l'algorithme de minimisation est décrit sur la figure 7. L'algorithme procède en testant à chaque itération une estimation de la matrice des signatures (1), en calculant pour ladite estimation de la matrice des signatures les courbes temporelles de consommation (2), et en calculant à partir desdites courbes de consommation la fonction objectif à minimiser (3). L'algorithme met alors à jour cette estimation de la matrice des signatures en fonction des valeurs de la fonction objectif obtenues tout au long de l'estimation.

### Présentation de l'algorithme final de décomposition

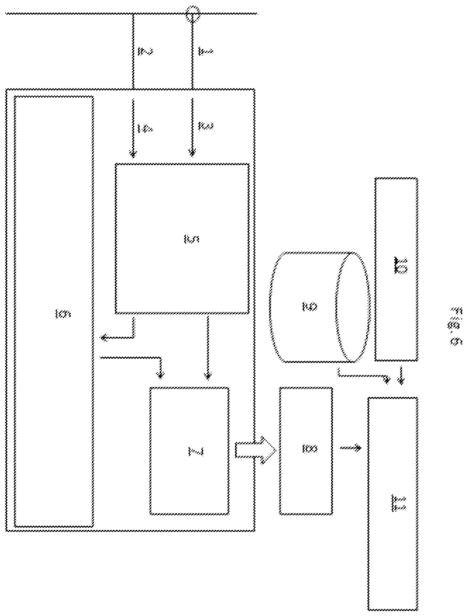

La figure 6 représente une vue schématique des traitements appliqués sur les signaux de courant et de tension, à la suite de l'étape d'extraction de signatures, jusqu'à l'étape finale de décomposition de la consommation globale en consommation suivant les équipements présents sur le site.

A nouveau, à partir des signaux mesurés de forme d'onde de courant (1) et de tension (2), on effectue les étapes de FFT et de débruitage temporel (3,4).

Afin d'obtenir la décomposition de la consommation des différentes signatures, on n'utilise pas exactement les signatures (6) obtenues à l'étape de configuration parce que les nouvelles signatures extraites sont constantes dans le temps, alors que les signatures réelles des appareils correspondant présentent des variations notamment dues à la FFT de la tension. De ce fait, la décomposition obtenue par la méthode de la pseudo-inverse de la matrice de signatures peut fournir des consommations négatives associées pour certaines signatures.

Pour cette raison, on procède pour la décomposition finale en fonction des signatures, à une deuxième étape d'optimisation sur des périodes plus courtes, de l'ordre de l'heure (5), où les signatures fixées sont encore calculées par rapport à la FFT de la tension, et les signatures extraites sont autorisées à être légèrement perturbées par rapport à leurs valeurs estimées dans l'étape de configuration.

A nouveau, cet algorithme (7) vise à minimiser une fonction objectif de la matrice des signatures, qui dépend directement des consommations associées aux différentes signatures. La fonction objectif est la somme de quatre sous-fonctions. La première sous-fonction pénalise fortement les valeurs de consommation négative, alors que les trois autres sous-fonctions pénalisent les écarts entre différentes quantités calculés avec la matrice de signatures obtenue à l'étape de configuration d'une part, et la matrice des signatures perturbées d'autre part. Ces quantités sont respectivement les courbes de consommation, les dérivées temporelles des courbes de consommation et la matrice des signatures elle-même.

Une fois que l'on dispose de la décomposition de la consommation globale en consommations associées aux différentes signatures, la dernière phase du procédé consiste à faire correspondre chaque signature à un équipement électrique sur le site, et donc à obtenir la décomposition de la consommation globale par équipements présents sur le site (11).

On utilise différentes sources d'information pour faire cette association de façon robuste et précise. D'une part la signature elle-même est caractéristique de certains types d'équipements, et d'autre part la courbe de consommation temporelle fournit aussi des informations discriminantes quant aux différents types d'équipements auxquels elle peut être associée. Ces deux informations principales sont mises en relation avec, d'une part une bibliothèque de signatures d'appareils électriques génériques et de signatures mesurées sur site (9), et d'autre part des informations sur le fonctionnement électrique des équipements présents sur le site (10), notamment leurs différents modes de fonctionnement et leurs puissances nominales.

### Variantes de réalisation

L'extraction des signatures basée sur l'observation des variations de consommation totale d'un réseau électrique peut mener au choix de signatures résultant de la combinaison de plusieurs appareils électriques unitaires aux fonctionnements synchronisés. La signature retenue ne permet donc pas d'isoler le fonctionnement de chacun des appareils concernés.

Afin d'apporter un niveau de discrimination supérieur, un traitement complémentaire vise à tenter de décomposer chaque signature extraite sur une base de signatures connues afin de déterminer si elle est unitaire ou non. Chaque signature extraite est projetée sur une base dont les directions représentent les signatures d'appareils électriques unitaires connus grâce à un algorithme d'optimisation, par exemple par minimisation de la distance entre la signature non unitaire et une combinaison pondérée de signatures unitaires. Un ou plusieurs indicateurs de performance indiquent la performance de cette projection.

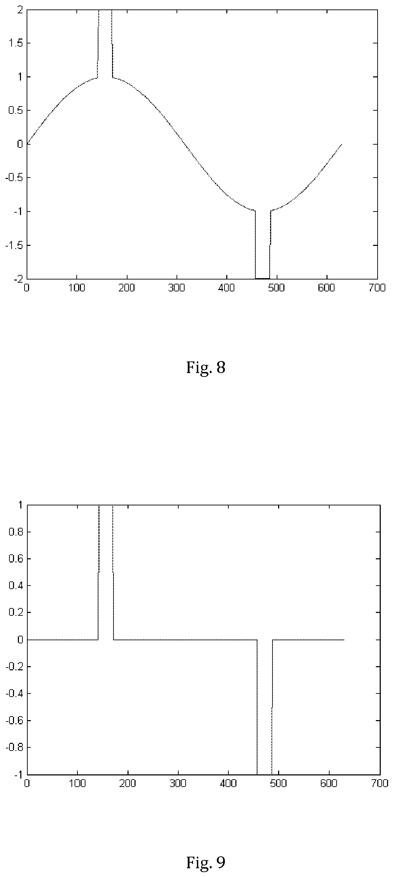

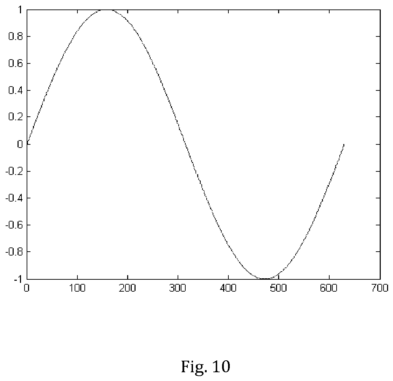

La figure 8 présente une forme d'onde non unitaire extraite. Les figures 9 et 10 présentent les formes d'onde unitaires résultant de la décomposition de la forme d'onde non unitaire.

Dans un premier mode de réalisation, cette projection est effectuée après extraction des signatures. Si les indicateurs de performance dépassent des seuils prédéfinis, la signature d'entrée est considérée comme non unitaire et est remplacée par les signatures unitaires qui la composent. La décomposition du signal global se base ensuite sur le catalogue augmenté de ces signatures unitaires.

Dans un second mode de réalisation, cette projection est effectuée après décomposition sur la base de signatures extraites. Si les indicateurs de performance dépassent des seuils prédéfinis, la signature d'entrée est considérée comme non unitaire et la courbe de charge associée à cette signature et résultant de l'algorithme de décomposition est séparée selon les poids relatifs fournis par la projection.

## Revendications

1. - Procédé d'analyse de la consommation d'électricité d'un site équipé d'une pluralité d'équipements électriques de natures différentes comprenant au moins une étape de mesure périodique du courant et de la tension sur au moins une des phases électriques en amont du réseau d'alimentation du site, ainsi qu'un traitement consistant à :
- échantillonner au moins le signal de courant à une fréquence au moins 30 fois supérieure à la fréquence fondamentale de la tension d'alimentation électrique
- appliquer une transformée de Fourrier sur chaque période fondamentale du signal de courant au moins
- procéder à un lissage temporel dudit signal transformé en calculant une moyenne temporelle sur une période caractéristique de changement de comportement des équipements du réseau, ladite période étant suffisamment longue par rapport à la période porteuse et suffisamment courte pour ne pas recouvrir plusieurs évènements,
- constituer une base de signatures adaptée au site étudié pendant une première étape de mise en oeuvre, consistant à :
∘ Enregistrer une matrice de signatures obtenues pour une pluralité d'appareils modélisés en agrégeant les différentes mesures de forme d'onde de tension et de courant capturées alors que l'appareil modélisé est alimenté par une série de formes d'onde de tension différentes
∘ faire évoluer itérativement les paramètres des signatures par un algorithme de minimisation consistant à tester à chaque itération une estimation de ladite matrice des signatures (1), en calculant pour ladite estimation de ladite matrice des signatures les courbes temporelles de consommation (2), et en calculant à partir desdites courbes de consommation la fonction objectif à minimiser (3) pour mettre à jour cette estimation de la matrice des signatures en fonction des valeurs de la fonction objectif obtenues tout au long de l'estimation
- utiliser ensuite ladite base de signatures de référence pour qualifier les évènements survenant sur ledit réseau.

2. - Procédé d'analyse de la consommation d'électricité d'un site équipé selon la revendication 1, **caractérisé en ce qu'**il comporte une étape additionnelle d'enregistrement d'une matrice de signatures dites préqualifiées obtenues pour une pluralité d'appareils modélisés en agrégeant les différentes mesures de forme d'onde de tension et de courant capturées alors que l'appareil modélisé est alimenté par une série de formes d'onde de tension différentes.

3. - Procédé d'analyse de la consommation d'électricité d'un site équipé selon la revendication 1 ou 2, **caractérisé en ce que** la signature d'une partie au moins desdits équipements est fonction d'une combinaison de signatures des éléments électriques mis en oeuvre par l'équipement considéré.

4. - Procédé d'analyse de la consommation d'électricité d'un site selon la revendication 1 ou 2 **caractérisé en ce que** le traitement d'analyse consiste à appliquer une première étape de calcul d'une transformée de Fourier Rapide sur les signaux de courant et de tension.

5. - Procédé d'analyse de la consommation d'électricité d'un site selon la revendication précédente **caractérisé en ce que** le traitement d'analyse consiste à appliquer une deuxième étape de décomposition du résultat de la transformée de Fourier Rapide en fonction des signatures caractéristiques de chacun desdits équipements.

6. - Procédé d'analyse de la consommation d'électricité d'un site selon la revendication 5 **caractérisé en ce que** le traitement d'analyse consiste à appliquer une étape additionnelle de validation des résultats de l'étape de décomposition consistant à vérifier la présence de variations temporelles des formes d'onde de courant de chacun des éléments reconnus.

7. - Procédé d'analyse de la consommation d'électricité d'un site selon l'une au moins des revendications précédentes **caractérisé en ce que** le traitement d'analyse comporte une étape additionnelle d'association des éléments reconnus pour identifier les équipements concernés.

8. - Procédé de modélisation des équipements en vue de la mise en oeuvre du procédé d'analyse selon l'une au moins des revendications précédentes, **caractérisé en ce que** l'on alimente les différents éléments électriques constitutifs dudit équipement par une tension de forme d'onde de référence, et d'enregistrement de données numériques représentatives de la forme d'onde des signaux de tension et de courant mesurés.

9. - Procédé de modélisation des équipements en vue de la mise en oeuvre du procédé d'analyse selon la revendication précédente **caractérisé en ce que** l'on enregistre pour chaque équipement un catalogue de signatures correspondant chacune à la forme d'onde des signaux de tension et de courant mesurés lors de l'alimentation avec une tension de forme d'onde différente.

10. - Procédé de modélisation des équipements en vue de la mise en oeuvre du procédé d'analyse selon l'une au moins des revendications précédentes, **caractérisé en ce qu'**il comporte en outre une étape de traitement complémentaire de décomposition de chaque signature extraite sur une base de signatures connues afin de déterminer si elle est unitaire ou non.

## Patentansprüche

1. Verfahren zum Analysieren des Elektrizitätsverbrauchs eines Orts, der mit einer Vielzahl von elektrischen Ausrüstungen verschiedener Arten ausgestattet ist, umfassend mindestens einen Schritt eines periodischen Messens des Stroms und der Spannung auf mindestens einer der elektrischen Phasen stromaufwärts des Versorgungsnetzes des Orts, sowie eine Verarbeitung, bestehend aus:
- Abtasten mindestens des Stromsignals mit einer Frequenz, die mindestens 30-mal höher als die Grundfrequenz der elektrischen Versorgungsspannung ist
- Anwenden einer Fourier-Transformation auf jede Grundperiode des Stromsignals mindestens
- Vornehmen einer zeitlichen Glättung des transformierten Signals, indem ein zeitliches Mittel über eine charakteristische Periode einer Verhaltensänderung der Ausrüstungen des Netzes berechnet wird, wobei die Periode relativ zu der Trägerperiode ausreichend lang und ausreichend kurz ist, um nicht mehrere Ereignisse zu überlappen,
- Bilden einer Basis von Signaturen, die an den untersuchten Ort angepasst ist, während eines ersten Implementierungsschritts, bestehend aus:
o Speichern einer Matrix von Signaturen, die für eine Vielzahl von modellierten Einrichtungen erhalten werden, indem die unterschiedlichen Messungen der Spannungs- und Stromwellenform zusammengefasst werden, die erfasst werden, während die modellierte Einrichtung durch eine Reihe von unterschiedlichen Spannungswellenformen versorgt wird
o iteratives Entwickeln der Parameter der Signaturen durch einen Minimierungsalgorithmus, der daraus besteht, bei jeder Iteration eine Schätzung der Matrix der Signaturen (1) zu testen, indem für die Schätzung der Matrix der Signaturen die zeitlichen Verbrauchskurven (2) berechnet werden und indem ausgehend von den Verbrauchskurven die zu minimierende Zielfunktion (3) zum Aktualisieren dieser Schätzung der Matrix der Signaturen in Abhängigkeit von den Werten der Zielfunktion berechnet wird, die während der ganzen Schätzung erhalten werden
- anschließend Verwenden der Basis von Referenzsignaturen zum Bezeichnen der Ereignisse, die in dem Netzwerk auftreten.

2. Verfahren zum Analysieren des Elektrizitätsverbrauchs eines ausgerüsteten Orts nach Anspruch 1, **dadurch gekennzeichnet, dass** es einen zusätzlichen Schritt des Speicherns einer Matrix von vorbezeichnet genannten vorqualifizierten Signaturen aufweist, die durch eine Vielzahl von modellierten Einrichtungen erhalten werden, indem die unterschiedlichen Messungen der Spannungs- und Stromwellenform zusammengefasst werden, die erfasst werden, während die modellierte Einrichtung durch eine Reihe von unterschiedlichen Spannungswellenformen versorgt wird.

3. Verfahren zum Analysieren des Elektrizitätsverbrauchs eines ausgerüsteten Orts nach in Anspruch 1 oder 2, **dadurch gekennzeichnet, dass** die Signatur eines Teils mindestens der Ausrüstungen abhängig von einer Kombination von Signaturen der elektrischen Elemente ist, die durch die berücksichtigte Einrichtung implementiert wird.

4. Verfahren zum Analysieren des Elektrizitätsverbrauchs eines Orts nach Anspruch 1 oder 2, **dadurch gekennzeichnet, dass** das Verarbeiten der Analyse das aus dem Anwenden eines ersten Schritts des Berechnens einer Fast-Fourier-Transformation auf die Strom- und Spannungssignale besteht.

5. Verfahren zum Analysieren des Elektrizitätsverbrauchs eines Orts nach dem vorstehenden Anspruch, **dadurch gekennzeichnet, dass** das Verarbeiten der Analyse aus dem Anwenden eines zweiten Schritts eines Zerlegens des Ergebnisses der Fast-Fourier-Transformation in Abhängigkeit von den charakteristischen Signaturen jeder der Ausrüstungen besteht.

6. Verfahren zum Analysieren des Elektrizitätsverbrauchs eines Orts nach Anspruch 5, **dadurch gekennzeichnet, dass** das Verarbeiten der Analyse aus dem Anwenden eines zusätzlichen Schritts eines Validierens der Ergebnisse des Zerlegungsschritts besteht, der daraus besteht, das Vorhandensein von zeitlichen Variationen der Stromwellenformen jedes der anerkannten Elemente zu verifizieren.

7. Verfahren zum Analysieren des Elektrizitätsverbrauchs eines Orts nach einem der vorstehenden Ansprüche, **dadurch gekennzeichnet, dass** das Verarbeiten der Analyse einen zusätzlichen Schritt eines Zuordnens der anerkannten Elemente zum Identifizieren der betroffenen Ausrüstungen umfasst.

8. Verfahren zum Modellieren der Ausrüstungen in Hinblick auf die Implementierung des Analyseverfahrens nach einem der vorstehenden Ansprüche, **dadurch gekennzeichnet, dass** die unterschiedlichen elektrischen Elemente, die die Ausrüstung bilden, durch eine Referenzwellenformspannung versorgt werden, und zum Speichern von digitalen Daten, die die Wellenform der Spannungs- und Stromstromsignale darstellen.

9. Verfahren zum Modellieren der Ausrüstungen in Hinblick auf die Implementierung des Analyseverfahrens nach dem vorstehenden Anspruch, **dadurch gekennzeichnet, dass** für jede Ausrüstung ein Signaturenkatalog gespeichert wird, der jeweils der Wellenform der Spannungs- und Stromsignale entspricht, die bei der Versorgung mit einer unterschiedlichen Wellenformspannung gemessen werden.

10. Verfahren zum Modellieren der Ausrüstungen in Hinblick die Implementierung des Analyseverfahrens nach einem der vorstehenden Ansprüche, **dadurch gekennzeichnet, dass** es ferner einen ergänzenden Verarbeitungsschritt des Zerlegens jeder extrahierten Signatur umfasst, die auf einer Basis von bekannten Signaturen basiert, um zu bestimmen, ob sie einheitlich ist oder nicht.

## Claims

1. Method for analyzing the electricity consumption of a site equipped with a plurality of different pieces of electrical equipment, comprising at least one step of periodically measuring the current and the voltage on at least one of the electrical phases upstream of the power network of the site, as well as processing consisting in:
- sampling at least the current signal at a frequency at least 30 times greater than the fundamental frequency of the electrical supply voltage
- applying a Fourier Transform over each fundamental period of the current signal at least
- proceeding with a temporal smoothing of said transformed signal by calculating a temporal average over a characteristic period of change in behavior of the pieces of equipment of the network, said period being sufficiently long with respect to the carrier period and sufficiently short as not to overlap a plurality of events,
- forming a database of signatures adapted to the site studied during a first implementation step, consisting in:
o recording a matrix of signatures which are obtained for a plurality of modeled apparatuses by aggregating the different voltage and current waveform measurements captured while the modeled apparatus is supplied by a series of different voltage waveforms
o iteratively changing the parameters of the signatures by a minimization algorithm consisting in testing, at each iteration, an estimation of the matrix of signatures (1) by calculating, for said estimation of the matrix of signatures, the temporal consumption curves (2) and by calculating, from the consumption curves, the objective function to be minimized (3) for updating this estimation of the matrix of signatures as a function of the values of the objective function which were obtained throughout the estimation
- subsequently using the database of reference signatures to qualify the events occurring on the network.

2. Method for analyzing the electricity consumption of a site equipped according to claim 1, **characterized in that** it comprises an additional step of recording a matrix of so-called pre-qualified signatures which are obtained for a plurality of modeled apparatuses by aggregating the different voltage and current waveform measurements captured while the modeled apparatus is supplied by a series of different voltage waveforms.

3. Method for analyzing the electricity consumption of a site equipped according to either claim 1 or claim 2, **characterized in that** the signature of at least part of the pieces of equipment is a function of a combination of signatures of the electrical elements implemented by the equipment in question.

4. Method for analyzing the electricity consumption of a site according to either claim 1 or claim 2, **characterized in that** the analysis processing consists in applying a first step of calculating a Fast Fourier Transform on the current and voltage signals.

5. Method for analyzing the electricity consumption of a site according to the preceding claim, **characterized in that** the analysis processing consists in applying a second step of breaking down the result of the Fast Fourier Transform as a function of the characteristic signatures of each of the pieces of equipment.

6. Method for analyzing the electricity consumption of a site according to claim 5, **characterized in that** the analysis processing consists in applying an additional step of validating the results of the break-down step consisting in verifying the presence of temporal variations in the current waveforms of each of the recognized elements.

7. Method for analyzing the electricity consumption of a site according to at least one of the preceding claims, **characterized in that** the analysis processing comprises an additional step of associating the recognized elements to identify the pieces of equipment in question.

8. Method for modeling the pieces of equipment with a view to implementing the analysis method according to at least one of the preceding claims, **characterized in that** the different electrical elements constituting the equipment are supplied by a reference waveform voltage, and recording digital data representative of the waveform of the voltage and current measurement signals.

9. Method for modeling the pieces of equipment with a view to implementing the analysis method according to the preceding claim, **characterized in that** a catalog of signatures is recorded for each piece of equipment, each signature corresponding to the waveform of the voltage and current measurement signals when supplied with a different waveform voltage.

10. Method for modeling the equipment with a view to implementing the analysis method according to at least one of the preceding claims, **characterized in that** it further comprises a complementary processing step of breaking down each extracted signature on a database of known signatures in order to determine whether it is unitary or not.
